# EUROPÄISCHE PATENTSCHRIFT

(11) **EP 2 751 520 B1**
(45) Veröffentlichungstag und Bekanntmachung des Hinweises auf die Patenterteilung: **01.04.2020**
(21) Anmeldenummer: 12743367.0
(22) Anmeldetag: 28.06.2012
(51) Int. Cl.: G01N 21/88, G01N 21/84, G01N 21/25, G01B 11/06

(54) **TESTGLASWECHSELN**
TEST GLASS CHANGING
CHANGEMENT DE VERRES D'ESSAI

(30) Priorität: 02.09.2011 DE 102011112085; 01.06.2012 DE 102012010794
(43) Veröffentlichungstag der Anmeldung: 09.07.2014
(73) Patentinhaber: Bühler Alzenau GmbH, 63755 Alzenau (DE)
(72) Erfinder: ZÖLLER, Alfons, 63628 Bad Soden-Salmünster (DE); HAGEDORN, Harro, 60435 Frankfurt am Main (DE); WIRTH, Eckhard, 63571 Gelnhausen (DE); WEINRICH, Werner, 63505 Langenselbold (DE); GROSS, Tobias, 30826 Garbsen (DE)
(74) Vertreter: Vossius & Partner Patentanwälte Rechtsanwälte mbB
(86) Internationale Anmeldenummer: PCT/EP2012/002723
(87) Internationale Veröffentlichungsnummer: WO 2013/029707

(56) Entgegenhaltungen:
- EP-A2- 0 241 589
- DE-A1-102005 010 681
- US-A1- 2007 041 091

## Beschreibung

Die vorliegende Erfindung betrifft ein Testglaswechseln bei der optischen Messung von Schichteigenschaften in Vakuumbeschichtungsanlagen nach den Oberbegriffen der unabhängigen Patentansprüche.

Aus der DE 10 2005 010 681 A1 ist eine Messanordnung zum optischen Monitoring von Beschichtungsprozessen bekannt. Diese Messanordnung hat eine hohe Messgenauigkeit für Transmissionsmessungen von Substraten oder Monitorgläsern, die auf bewegten Substrathaltern angeordnet sind. Hierbei befindet sich die Lichtquelle innerhalb der Vakuumkammer zwischen einem Substrathalter und einer unterhalb des Substrathalters angeordneten Blende. Die Lichtempfängereinheit ist außerhalb der Vakuumkammer im Strahlengang der Lichtquelle angeordnet. Der Substrathalter ist zur Aufnahme von zumindest einem Substrat ausgelegt und kann sich in der Vakuumkammer über eine Beschichtungsquelle bewegen. Vorzugsweise rotiert er um eine Achse, wobei das zumindest eine Substrat den Strahlengang zwischen der Lichtquelle und der Lichtempfängereinheit zur Transmissionsmessung kreuzt und die Blende einen Messbereich über der Beschichtungsquelle abschattet.

Bei dieser Messanordnung wird die Transmission eines ausgewählten Substrats oder Monitorglases auf dem rotierenden Substrathalter intermittierend gemessen. Bei Beschichtungsprozessen mit sehr vielen Schichten hat sich in der Praxis gezeigt, dass Fehlerakkumulationen zu beträchtlichen Schichtdickenfehlern führen können. Um solche Fehlerakkumulationen zu unterbrechen, ist es häufig von Vorteil, das Messglas nach einer bestimmten Anzahl von Schichten gegen ein unbeschichtetes Glas zu wechseln. Bei vielen Schichtsystemen ist ein Wechsel nach ca. 30 bis 40 Schichten erforderlich. Bei der beschriebenen Messanordnung kann das Monitorglas nur bei geöffneter Vakuumkammer manuell gewechselt werden. Dieser manuelle Wechsel führt zu zeitaufwändigen Prozessunterbrechungen. Ferner können die Substrate durch das Öffnen und Belüften und das anschließende erneute Evakuieren mit Partikeln kontaminiert werden. Selbst bei zusätzlichen Reinigungsschritten hat sich in der Praxis gezeigt, dass die Partikelkontamination deutlich größer ist als bei Prozessen ohne derartige Prozessunterbrechungen.

Ferner ist aus der EP 0 241 589 B1 ein Testglaswechsler der eingangs genannten Art beschrieben, bei dem eine Halterung für die Aufnahme mehrerer Testgläser an einem Substrathalter gelagert und mit diesem beweglich und relativ zum Substrat in sich beweglich angeordnet ist. Der beschriebene Testglaswechsler weist eine für den Betrieb unter Vakuum geeignete Steuereinrichtung für die Einführung jeweils eines Testglases in einen Strahlengang einer Messvorrichtung und mindestens einen Strom eines Beschichtungsmaterials auf.

Mit diesem Testglaswechsler konnte ein Nachteil des Standes der Technik überwunden werden, indem Testgläser im Vakuum ohne Belüftung der Vakuumkammer gewechselt werden können. Allerdings haben sich auch bei diesem Testglaswechsler Nachteile gezeigt. Insbesondere muss ein Vorsprung der Halterung von einem Schaltfinger exakt solange blockiert werden, bis ein vorher berechneter Drehwinkel der Halterung erreicht ist. Der erforderliche Drehwinkel beträgt [360° / Anzahl der Testgläser]. Weiterhin muss sicher gestellt werden, dass sich ein Testglas nach Durchlaufen des Drehwinkels exakt zentrisch im Strahlengang der optischen Messung befindet. Hierzu ist eine sehr präzise mechanische Abstimmung des Schaltfingers und der Vorsprünge erforderlich. Ebenso muss der zeitliche Ablauf sehr genau koordiniert werden. In der Praxis hat sich gezeigt, dass die exakte Zentrierung und die sehr präzise mechanische Abstimmung nur schwer zu erfüllen sind, was zu ungenauen und folglich nicht reproduzierbaren Positionierungen der Testgläser führt. Aufgrund der Drehung des Substrathalters während der Beschichtung kann sich die Halterung mit den Testgläsern leicht bewegen, was zusätzlich zu einer unerwünschten Verschiebung der Testglasposition führt.

Aus der US 2007/0041091 A1 ist bereits ein Mikroskop mit einem Drehteller bekannt, wobei der Drehteller um einen Schaft gedreht werden kann. An dem Drehteller sind clickgrooves angeordnet. Ferner ist ein Klickmechanismus vorgesehen, der aus den clickgrooves, einer Lagerung, einem Arm und einer Feder besteht. Mittels des Klickmechanismus' können optische Elemente selektiv in einer optischen Beobachtungsachse positioniert werden. Ein Zahngetriebe ist als Rändelung am äußeren Umfang des Drehtellers angeordnet und mit einem Getriebe verzahnt, das wiederum mit einem Kegelradgetriebe verzahnt ist. Das Kegelradgetriebe ist mit einem weiteren Kegelradgetriebe am Ende einer Rotationsachse angeordnet und erstreckt sich in longitudinaler Richtung des Mikroskops. Mit dem Klickmechanismus kann ein Haltemoment auf den Drehteller angewendet werden, das die optischen Elemente in einer bestimmten Position hält. Von dem Getriebemechanismus wird ein Drehmoment auf den Drehteller angewendet.

Aus der US 2002/0176097 A1 sind ein Apparat und eine Methode für eine Dünnfilmbeschichtung von Substraten bekannt mit einem mechanischen Apparat, um eine super-planetarische und planetarische Bewegung eines jeden Substrates während der Beschichtung zu ermöglichen. Während der Beschichtung wird die Schichtdicke durch ein optisches Instrument überwacht, dass eine lineare Messachse aufweist, die mit dem Zentrum der planetarischen Bewegung des Substrates übereinstimmt. Die Vorrichtung umfasst eine Halterung, welche starr mit einer Drehachse verbunden und um die Drehachse drehbar ist, sowie ferner eine Steuereinrichtung, wodurch eine Drehbewegung der Halterung bewegbar ist. Die Halterung umfasst ferner ein oder mehrere Getriebe und Lagerelemente, sowie Klammern, Federn, Schrauben oder der Gleichen, mit denen die Substrate lösbar fixiert werden können. Dabei ist die Halterung derart konstruiert, dass eine optische Überwachung des Substrates über einen optischen Weg möglich ist, wobei Öffnungen in der Halterung vorgesehen sind um einen optischen Zugang zu den Substraten zu erlauben. Mittels eines super-planetarischen Antriebmotors können ein Drehmoment und ein Haltemoment auf die Halterung ausgeübt werden.

Der Erfindung liegt daher die Aufgabe zugrunde, ein Testglaswechseln der eingangs beschriebenen Art zu verbessern.

Diese Aufgabe wird durch die Merkmale der unabhängigen Ansprüche gelöst. Vorteilhafte Weiterbildungen des Testglaswechslers sind in den Unteransprüchen definiert.

Der erfindungsgemäße Testglaswechsler zeichnet sich dadurch aus, dass eine Zentriereinrichtung vorgesehen ist, die zumindest ein winkelstarr zum Substrathalter angeordnetes Aktorelement und zumindest ein winkelstarr zur Drehachse angeordnetes und vom Aktorelement mit Federkraft beaufschlagbares Lagerelement aufweist, wobei ausgehend von der ersten Position von der Zentriereinrichtung ein Drehmoment auf die Halterung ausübbar ist, um das Testglaselement in die Messposition zu bringen und durch das Eingreifen des Aktorelementes in das Lagerelement ein Haltemoment auf die Halterung ausübbar ist, um das Testglaselement in der Messposition zu halten, wobei
a) das Lagerelement als eine mit der Drehachse starr verbundene Nabe mit einer Anzahl von am Umfang der Nabe angeordneten Vertiefungen ausgebildet ist und zumindest eine der Vertiefungen einer der Ausnehmungen entspricht, und das Aktorelement als an der Trägerscheibe angeordneter Federbolzen ausgebildet ist, der mit einem freien Ende mit Federkraft in eine der Vertiefungen eingreifen kann, oder
b) das Lagerelement als in der Halterung angeordnete muldenartige Vertiefung ausgebildet ist, wobei die Vertiefung einer der Ausnehmungen entspricht und das Aktorelement eine auf der Trägerscheibe einseitig fixierte Blattfeder, ein zwischen der Halterung und der Trägerscheibe angeordnetes Kugelelement umfasst wobei das Kugelelement eine in der Trägerscheibe angeordnete Anschlagöffnung und das Kugelelement mit Federkraft der Blattfeder in die Vertiefung eingreifen kann.

Damit ist auf einfache Weise eine genaue Positionierung des Testglaselements zur Beschichtung mit dem Beschichtungsmaterial und zur Durchführung der Messung daran möglich, ohne zum Wechseln und/oder Positionieren des Testglaselements die Vakuumkammer zu belüften und ohne eine sehr präzise mechanische Abstimmung verschiedener Komponenten zur Positionierung vornehmen zu müssen.

Das Testglaselement kann hier insbesondere ein kreisförmiges oder ovalförmiges Testglas sein. Ferner kann das Testglaselement als Teil-Glasring ausgebildet sein, der sich über einen Kreissektor erstreckt.

Eine Ausführungsform zeichnet sich dadurch aus, dass die Zentriervorrichtung zumindest ein winkelstarr zum Substrathalter angeordnetes Aktorelement und zumindest ein winkelstarr zur Drehachse angeordnetes und vom Aktorelement mit Federkraft beaufschlagbares Lagerelement aufweist. Es kann dann beim Eingreifen des Aktorelements in das Lagerelement die Positionierung der mit der Drehachse fest verbundenen scheibenartigen Halterung und damit des jeweiligen Testglaselements exakt ausgeführt werden, da das Aktorelement über das Lagerelement ein Haltemoment auf die Drehachse mit der Halterung ausübt, so dass die Halterung in ihrer Position zum Substrathalter zumindest so lange fixiert wird, bis die Halterung planmäßig weitergedreht wird.

In einer weiteren Ausführungsform kann eine an dem Substrathalter befestigbare oder befestigte Trägerscheibe mit einer Durchführung für die Drehachse und wenigstens einer exzentrisch zur Drehachse angeordneten Messöffnung vorgesehen sein, wobei die Halterung in einem Raumbereich zwischen Substrathalter und der Trägerscheibe angeordnet ist.

Die Trägerscheibe dient in dieser Ausführungsform u.a. zur Aufnahme des Aktorelements, trägt dieses daher und fixiert es winkelstarr in Bezug auf den Substrathalter. Somit kann das Aktorelement in das Lagerelement auf der durch die Trägerscheibe führenden Drehachse eingreifen und eine genaue Positionierung einstellen. Ferner gibt die exzentrische Messöffnung nur einen Strahlengang für die Messung frei, während weitere eventuell vorhandene Testglaselemente gegenüber dem Bereich der Vakuumkammer oberhalb der Trägerscheibe durch die Trägerscheibe geschützt sind.

Eine weitere Ausführungsform zeichnet sich dadurch aus, dass das Lagerelement als eine mit der Drehachse starr verbundene Nabe mit einer Anzahl V am Umfang der Nabe angeordneten Vertiefungen ausgebildet ist, wobei zumindest eine der Vertiefungen einer der Ausnehmungen entspricht, und dass das Aktorelement als an der Trägerscheibe angeordneter Federbolzen ausgebildet ist, der mit einem freien Ende mit Federkraft in eine der Vertiefungen eingreifen kann.

Eine dazu alternative Ausführungsform zeichnet sich dadurch aus, dass das Lagerelement als in der scheibenartigen Halterung angeordnete muldenartige Vertiefung ausgebildet ist, wobei die Vertiefung einer der Ausnehmungen entspricht, und dass das Aktorelement ein Kugelelement, eine in der Trägerscheibe angeordnete obere Anschlagöffnung des zwischen scheibenartiger Halterung und der Trägerscheibe anordenbaren oder angeordneten Kugelelements und ein an der Trägerscheibe angeordnetes und das Kugelelement beaufschlagendes Federelement umfasst, wobei das Kugelelement mit Federkraft in die Vertiefung eingreifen kann.

Beide Alternativen haben den Vorteil, dass durch den Eingriff des Federbolzens bzw. des Kugelelements in eine der entsprechenden Vertiefungen die Positionierung sehr exakt möglich ist, insbesondere, wenn die Radien des Federbolzenendes bzw. des Kugelelements mit den Radien der entsprechenden Vertiefungen aufeinander abgestimmt sind, so dass der Federbolzen bzw. das Kugelelement im wesentlichen ohne Spiel in die entsprechende Vertiefung eingreifen.

Nach einer weiteren Ausführungsform umfasst die Steuereinrichtung eine Anzahl von Dreharmen oder Vorsprüngen, deren Anzahl der Zahl der Ausnehmungen entspricht. Mittels der Dreharme oder Vorsprünge kann ein Drehmoment auf die Drehachse aufgebracht werden. Ferner sind in die jeweilige Umlaufbahn der Dreharme oder Vorsprünge hineinbewegbare Schaltfinger vorgesehen, so dass die Halterung mittels der Dreharme oder Vorsprünge um einen Winkelabstand drehbar ist.

Dadurch, dass die Anzahl der Dreharme bzw. Vorsprünge den Ausnehmungen entspricht, deren Anzahl wiederum vorzugsweise der Anzahl der in der Halterung angeordneten Testglaselemente entspricht, kann durch das Eingreifen des Schaltfingers in einen der Dreharme oder Vorsprünge auf einfache und effiziente Weise ein weiteres Testglas in die Messposition hineingedreht werden, ohne eine aufwendige mechanische Abstimmung durchführen zu müssen. Es kann sogar ausreichen, den Schaltfinger nur für einen kurzen Zeitraum in die Umlaufbahn der Dreharme bzw. Vorsprünge hineinzubewegen, um einen Dreharm bzw. einen Vorsprung mitzunehmen wird.

Zwischen der Halterung und der Substrathalterung ist eine Schutzvorrichtung gegenüber Einflüssen aus dem Bereich der Vakuumkammer unterhalb des Substratträgers angeordnet ist so dass jeweils nur ein einziges Testglaselement in seiner Beschichtungs- und Messposition frei gelassen ist. Es ist bevorzugt, dass an der Trägerscheibe eine Schutzvorrichtung angeordnet ist, so dass jeweils nur ein einziges Testglaselement in seiner Beschichtungs- und Messposition frei gelassen ist. Dabei kann die Schutzvorrichtung insbesondere eine koaxial zur Drehachse angeordnete Kreisscheibe sein, die eine einzige mit der Messposition zur Deckung bringbare Öffnung aufweist.

Die Schutzvorrichtung, insbesondere in Form einer Kreisscheibe, stellt einen einfachen, aber wirkungsvollen Schutz der Halterung einschließlich ihrer beweglichen Teile sowie der nicht zur Beschichtung gedachten Testglaselemente vor einer Beschichtung dar. Die Schutzvorrichtung gibt nur die Beschichtung des Testglaselementes in der Messposition frei.

Neben der vorstehend genannten Transmissionsmessung können die Schichteigenschaften an den Testglaselementen auch in Reflexion gemessen werden. Bei der Reflexionsmessung kann die Trägerscheibe ohne Öffnung ausgeführt sein.

Das erfindungsgemäße Verfahren zum Testglaswechseln mittels einer vorangehend beschriebenen Vorrichtung zeichnet sich dadurch aus, dass bevor ein in einer der Ausnehmungen angeordnetes Testglaselement in eine Messposition der Messvorrichtung gebracht wird, mittels der Steuereinrichtung eine Drehbewegung der Halterung bewirkt wird, durch die dieses Testglaselement in eine erste Position gebracht wird, die einen kleineren Winkelabstand von der Messposition aufweist, als der Winkelabstand zwischen den Ausnehmungen beträgt und anschließend mittels der Zentriereinrichtung dieses Testglaselement in die Messposition gebracht wird.

Weitere Ziele, Merkmale, Vorteile und Anwendungsmöglichkeiten ergeben sich aus der Beschreibung von bevorzugten Ausführungsbeispielen der Erfindung anhand der beigefügten Zeichnungen. Dabei bilden alle beschriebenen und/oder bildlich dargestellten Merkmale für sich oder in beliebiger Kombination den Gegenstand der Erfindung, auch unabhängig von ihrer Zusammenfassung in den Ansprüchen oder deren Rückbeziehung.
- Fig. 1: zeigt einen Testglaswechsler nach einer Ausführungsform der Erfindung mit einer Nabe in einer ersten Position in Bezug auf einen Federbolzen.
- Fig. 2: zeigt den in Fig. 1 dargestellten Testglaswechsler mit einer Nabe in einer zweiten Position in Bezug auf einen Federbolzen.
- Fig. 3: zeigt eine Abdeckscheibe für einen Testglaswechsler nach einer Ausführungsform der Erfindung.
- Fig. 4: zeigt einige Komponenten einer weiteren Ausführungsform eines erfindungsgemäßen Testglaswechslers.
- Fig. 5: zeigt die Anordnung eines Testglaswechslers nach einer Ausführungsform der Erfindung auf einem Substrathalter in Relation zu einer Schalteinrichtung mit einem Schaltfinger in einer ersten Betriebsposition.
- Fig. 6: zeigt die in Fig. 5 dargestellte Anordnung mit dem Schaltfinger in einer zweiten Betriebsposition.
- Fig. 7: zeigt ein Aktorelement und ein Lagerelement einer weiteren Ausführungsform der Erfindung.
- Fig. 8: ein Blockschaltbild einer Automatisierung zum Testglaswechseln.

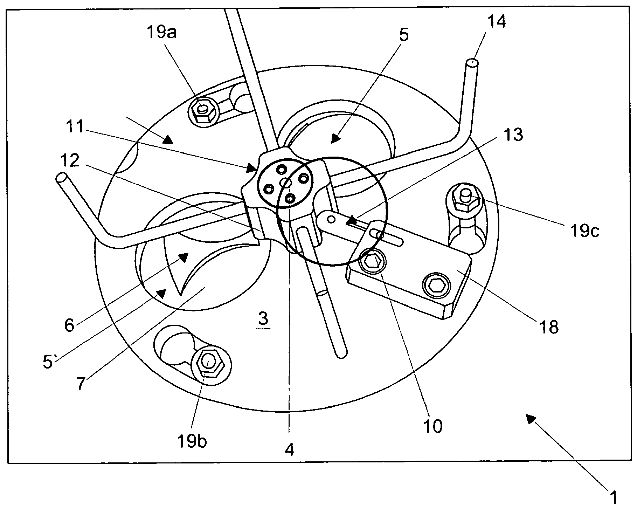

In Fig. 1 ist eine bevorzugte Ausführungsform des Testglaswechslers 1 dargestellt. Im weiteren wird die in Fig. 1 sichtbare Seite des Testglaswechslers als Oberseite und die nicht sichtbare Seite als Unterseite bezeichnet, ohne dies für den Gegenstand der Erfindung eingrenzend zu meinen.

Eine Trägerscheibe 3, die in der vorliegenden Ausführungsform kreisrund dargestellt ist, weist in ihrer Mitte eine in Fig. 1 nicht sichtbare Durchführung auf, durch welche eine Drehachse 4 führt.

Unterhalb der Trägerscheibe 3 ist eine Halterung 6 für die Aufnahme von Testglaselementen vorgesehen. Die Testglaselemente können kreisförmig, ovalförmig oder als Glas-Teilring ausgebildet sein. Die Trägerscheibe 3 weist in der vorliegenden Ausführungsform eine Öffnung 5' auf, die exzentrisch angeordnet ist, durch die Testglaselemente in die Halterdung 6 eingelegt oder entnommen werden können.

In der vorliegenden Ausführungsform weist die Halterung 6 vier Öffnungen 7 zur Aufnahme der Testglaselemente auf. Die Halterung 6 ist in dieser Ausführungsform als kreisrunde Scheibe ausgeführt und in ihrer Mitte starr mit der Drehachse 4 verbunden. Die Halterung 6 ist gemeinsam mit der Drehachse 4 und der Nabe 11 drehbar gegenüber der Trägerscheibe 3 gelagert.

Die Öffnungen 7 in der Halterung 6 können als kreisrunde Bohrungen ausgebildet sein, deren maximaler Durchmesser geringfügig kleiner ist als der Durchmesser der verwendeten Testglaselemente. Insbesondere sind die Bohrungen als Sacklöcher ausgeführt. Durch den Unterschied der Radien ergibt sich ein Auflagerand des Testglaselementes auf der Öffnung 7 in der Halterung 6.

Die Zentriervorrichtung weist zumindest ein winkelstarr zum Substrathalter angeordnetes Aktorelement (Aktuatorelement) und zumindest ein winkelstarr zur Drehachse angeordnetes und vom Aktorelement, vorzugsweise mit Federkraft beaufschlagbares Lagerelement auf. Als Federkraft wird hier jede durch ein elastisches Element bewirkte Kraft verstanden, insbesondere eine Spannkraft einer Feder.

Auf der Oberseite der Trägerscheibe 3 ist als Lagerelement eine Nabe 11 angeordnet und fest mit der Drehachse 4 verbunden. Die Nabe 11 ist zusammen mit der Drehachse 4 gegenüber der Trägerscheibe 3 drehbar. Die Nabe 11 weist auf ihrem Umfang vier, in axialer Richtung verlaufende Vertiefungen 12 auf, in die als Aktorelement ein beweglicher Federbolzen 13 eingreift. Die Nabe 11 mit den Vertiefungen 12 und dem Federbolzen 13 bilden zusammen die Zentriervorrichtung 10.

Zwischen den Vertiefungen 12 sind an den Erhöhungen der Nabe 11 Dreharme 14 vorgesehen, die sich zunächst parallel zur Trägerscheibe 3 radial nach außen erstrecken, um dann im Bereich des radial äußersten Randes der Trägerscheibe 3 nach oben hin in einen Winkel von ca. 90° abzuwinkeln. Die Dreharme können auch an der Drehachse 4 angebracht sein.

Der Federbolzen 13 ist in einer Federbolzenlagerung 18 gelagert, die eine Bewegung des Federbolzens 13 in radialer Richtung der Drehachse 4 ermöglicht. Die Lagerung 18 ist fest, aber vorzugsweise abnehmbar mit der Trägerscheibe 3 verbunden. Im vorliegenden Fall ist die Lagerung 18 als Zylinderblock ausgeführt und mit der Trägerscheibe 3 verschraubt. Bei der Drehung der Nabe 11 wird der Federbolzen 13 gegen die Federkraft aus der Vertiefung 12 heraus auf die Erhöhung der Nabe 11 zwischen zwei Vertiefungen 12 gedrückt.

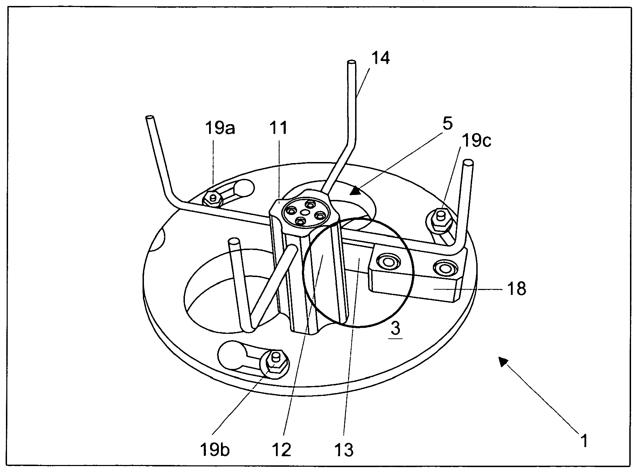

In Fig. 2 wird die Nabe 11 in einer Stellung zu dem Federbolzen 13 gezeigt, bei der dieser in der Mitte zwischen zwei Vertiefungen 12 steht und den maximalen Abstand zwischen Drehachse 4 und Federbolzen 13 hat. Wird nun die Drehachse 4 durch die Bewegung der Dreharme 14 geringfügig gegenüber der Trägerscheibe 3 verdreht, läuft der Federbolzen 13 durch seine Federkraft in die nächste Vertiefung 12 hinein und positioniert sich genau in der Mitte dieser Vertiefung 12. Solange kein Drehmoment beaufschlagt wird, wird die Nabe 11 und damit die Halterung 6 mit den Testglaselementen durch die Federkraft des Federbolzens 13 an ihrer Position gehalten.

Die Trägerscheibe 3 weist in der vorliegenden Ausführungsform eine weitere exzentrisch angeordnete Öffnung 5 auf, die im in einem Strahlengang, beispielsweise für Transmissionsmessungen liegt.

Die Trägerscheibe 3 ist fest mit dem Substrathalter 2 verbunden, in dieser Ausführungsform mittels der Schrauben 19a, 19b, 19c, die die Trägerscheibe 3 in der Art eines BajonettVerschlusses befestigen.

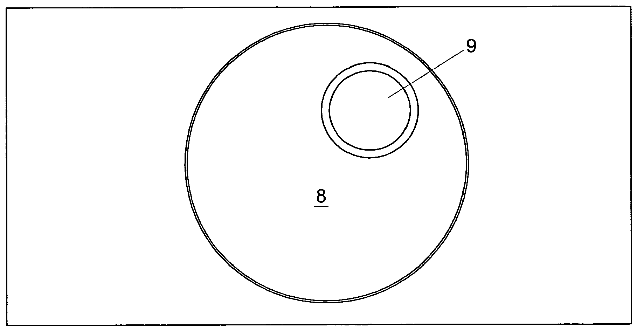

Fig. 3 zeigt eine Abdeckscheibe 8, die an der Unterseite der Trägerplatte 3 befestigt ist oder befestigbar ist. Dabei lässt die Befestigung der Abdeckscheibe 8 an der Trägerplatte 3 genug Raum für die Drehung der Halterung 6 mit den Testglaselementen. Die Abdeckscheibe 8 weist eine Öffnung 9 auf, die in radialer Richtung so positioniert ist, dass sie mit der Öffnung 5 in der Trägerscheibe 3 zur Deckung kommt. Durch die Positionierung der Öffnung 7 in der Halterung 6 mittels der Vertiefungen 12 in der Nabe 11 und des Federbolzens 13 wird das jeweilige Testglas exakt in der Öffnung 5 der Trägerscheibe 3 und der Öffnung 9 in der Abdeckscheibe 8 positioniert.

In einer weiteren Ausführungsform sind eine Trägerscheibe, Abdeckscheibe und eine Abdeckung mittels der Schrauben miteinander verbunden und bilden eine Einheit, die vormontiert auf die Kalotte gesetzt werden kann.

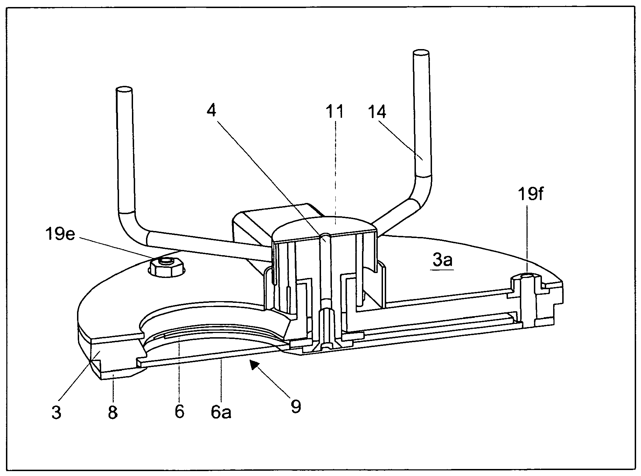

Fig. 4 zeigt bei einer Ausführungsform des erfindungsgemäßen Testglaswechslers eine Trägerplatte 3 mit einer auf dieser angeordneten Abdeckung 3a. Unterhalb der Trägerplatte 3 ist als Schutzvorrichtung eine Abdeckplatte 8 angeordnet, die analog zur Ausführungsform der Fig. 3 eine Öffnung 9 aufweist, durch die ein Testglas 6a von unten beschichtet werden kann. Die Abdeckplatte 8 ist mittels Schrauben 19e, 19f mit der Unterseite der Trägerplatte 3 verbunden, wobei die Halterung 6 zwischen Abdeckplatte 8 und Trägerplatte 3 bewegbar ist.

In den dargestellten Ausführungsformen wird die Beschichtung der Substrate und damit die Beschichtung der Testglaselemente von unten ausgeführt. Die Abdeckscheibe 8 begrenzt durch ihre eine Öffnung 9 die Beschichtung auf genau das Testglas, das in den Öffnungen 5 und 9 positioniert ist. Durch diese Anordnung der Öffnung 5 in der Trägerscheibe 3, der Öffnung 7 in der Halterung 6 mit den Testglas und der Öffnung 9 in der Abdeckscheibe 8 wird der Strahlengang für die Transmissionsmessung des aktuellen Testglaselementes freigegeben.

Um ein neues Testglas in den Strom des Beschichtungsmaterials und ebenso in den Strahlengang für die Transmissionsmessung zu bringen, wird mittels der Dreharme 14, der Nabe 11 und der Drehachse 4 die Halterung 6 gegenüber der Trägerscheibe 3 und der Abdeckscheibe 8 verdreht und das auf einer Kreisbahn in der Halterung 6 angeordnete nächste Trägerglas positioniert.

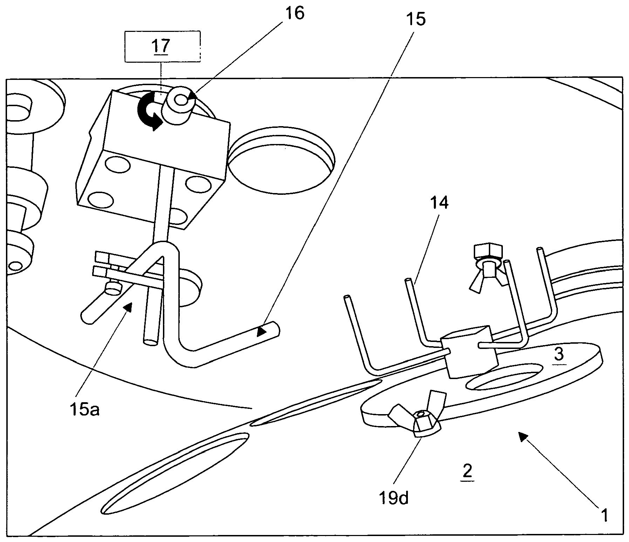

Fig. 5 zeigt die Anordnung des Testglaswechslers 1 auf dem Substrathalter 2, der in dieser Ausführungsform als drehbare Kalotte ausgeführt ist. Der Testglaswechsler 1 ist in einer entsprechenden Öffnung mit der Kalotte mittels einer Schraube 19d verschraubt. Dabei weist die Unterseite des Testglaswechslers 1, das heißt die Abdeckscheibe 8, in das Innere der Kalotte. Die Nabe 11 mit den Dreharmen 14 ist auf der Außenseite der Kalotte angeordnet.

Unabhängig von der Kalotte ist in Relation zu dem Testglaswechsler 1 eine Schalteinrichtung vorgesehen, die aus einem Schaltfinger 15 besteht, der über eine Welle 16 mit einem Aktuator 17 verbunden ist, wodurch der Schaltfinger 15 angetrieben werden kann. Durch die Bewegung der Welle 16 kann der Schaltfinger 15 in Richtung des Testglaswechslers 1 geschwenkt werden. Zum Justieren des Schaltfingers 15 ist eine Gelenkvorrichtung 15a an der Welle 16 angeordnet.

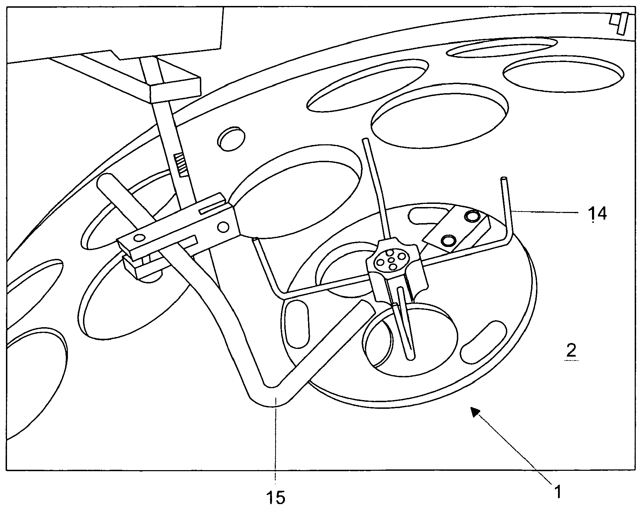

Wie in Fig. 6 gezeigt ist, befindet sich der Schaltfinger 15 nach dem Umschwenken zwischen zwei Dreharmen 14 des Testglaswechslers 1. Wird nun während des Beschichtungsvorgangs die Kalotte gedreht, so kommt einer der Dreharme 14 in Kontakt mit dem Schaltfinger 15, so dass durch die Drehung der Kalotte eine Drehung der Nabe 11 mit der Drehachse 4 ausgelöst wird. Damit wird die Halterung 6 mit den Testglaselementen gegenüber den mit der Kalotte verdrehsicher verbundenen Komponenten Trägerscheibe 3 und Abdeckscheibe 8 verdreht.

Wenn durch die Drehung der Kalotte die Drehung der Nabe 11 so weit geführt wurde, dass der Federbolzen 13 den Punkt mit dem maximalen Abstand zwischen Drehachse 4 und Federbolzen 13 überschritten hat, wird der Schaltfinger 15 durch die Wirkung des Aktuators 17 über eine Drehung der Welle 16 zurückgeschwenkt. Die Federkraft des Federbolzens 13 führt zur exakten Positionierung der Nabe 11 und damit zur präzisen Zentrierung des nächstens Testglaselementes in den zur Deckung gebrachten Öffnungen 5, 7 und 9.

In der vorliegenden Ausführungsform wird die Welle 16 durch eine Vakuumdurchführung aus der Vakuumbeschichtungskammer nach außen geführt, wo der Aktuator 17 angeordnet ist. Durch die Vakuumdurchführung kann die Welle 16 leicht manuell oder motorisch bewegt werden.

Es versteht sich, dass auch weitere Ausführungsformen eines Antriebs des Schaltfingers 15 von der Erfindung umfasst werden. Insbesondere kann ein Schwenkantrieb des Schaltfingers 15 eine Drehachse mit einer anderen Orientierung aufweisen, als in Figur 5 dargestellt ist.

Zur Drehung der Kalotte wird der vorhandene und in der Figur nicht dargestellte Drehantrieb verwendet. Vorzugsweise wird während des Testglaswechsels die Kalotte langsamer gedreht als während eines regulären Beschichtungsvorgangs. Insbesondere kann mit Hilfe eines Winkelgebers, der mit dem Drehantrieb der Kalotte gekoppelt ist, der Wechselvorgang sehr leicht automatisiert werden.

Alternativ zum vorhergehenden ist es auch möglich, die Dreharme 14 bei stehender Kalotte zu verdrehen. Hierzu muss der Schaltfinger 15 zu seinem Einschwenken zwischen zwei Dreharme 14 zusätzlich mechanisch verdreht werden, um die Schaltfinger 15 soweit zu führen, dass der Federbolzen 13 in die nächste Vertiefung 12 geführt wird.

Der erfindungsgemäße Testglaswechsler 1 ermöglicht durch die Selbstzentrierung mit Hilfe des Federbolzens 13 eine exakte Positionierung eines Testglaselementes im Strom des Beschichtungsmaterials und/oder im Strahlengang der Transmissionsmessung. Gegenüber dem Stand der Technik ist die Wechselmöglichkeit der Testglaselemente auch bei stehenden Substrathaltern möglich.

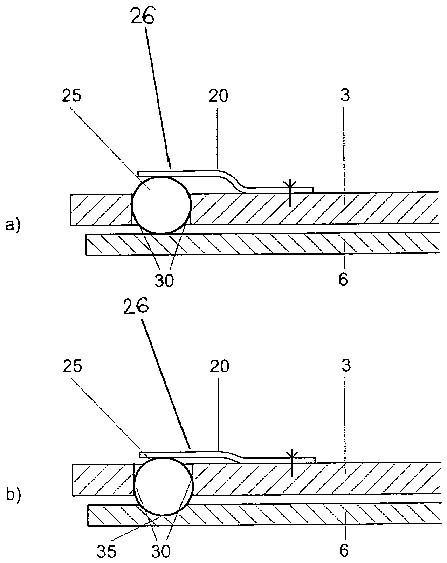

Alternativ zur Positionierung mit Federbolzen und Nabe, können Aktorelement und Lagerelement auch wie in Figur 7 dargestellt ausgebildet sein.

Auf der Trägerscheibe 3 ist eine Blattfeder 20 einseitig fixiert. Zwischen Trägerscheibe 3 und Halterung 6 für die Testglaselemente befindet sich eine Kugel 25. Die Trägerscheibe 3 ist mit einer kreisrunden Anschlagsöffnung 30 versehen, welche derartig gestaltet ist, dass die Kugel 25 einen oberen Anschlag hat. Die Kugel 25 wird mittels Federkraft nach unten auf die Halterung 6 gedrückt; vgl. Figur 7a, die die Anordnung bei nicht positioniertem Testglas während eines Wechselvorganges zeigt.

Die Halterung 6 für die Testglaselemente ist mit muldenartigen Vertiefungen 35 (Kuhlen) versehen, welche so angeordnet sind, das die Kugel 25 in eine der Kuhlen 35 gedrückt wird, wenn sich ein Testglas in Messposition befindet, vgl. Figur 7 b. Aufgrund des Federdruckes auf die Kugel 25 wird die Haltescheibe 6 angehalten und fixiert. Für den nächsten Wechsel wird die Haltescheibe 6 über die Drehachse von einem Dreharm mit einer Kraft gedreht, welche die Federkraft überwindet. Die Kuhle 35 verlässt den Bereich der Kugel 25 und die die Haltescheibe 6 drückt die Kugel 25 nach oben wie in Figur 7 a dargestellt.

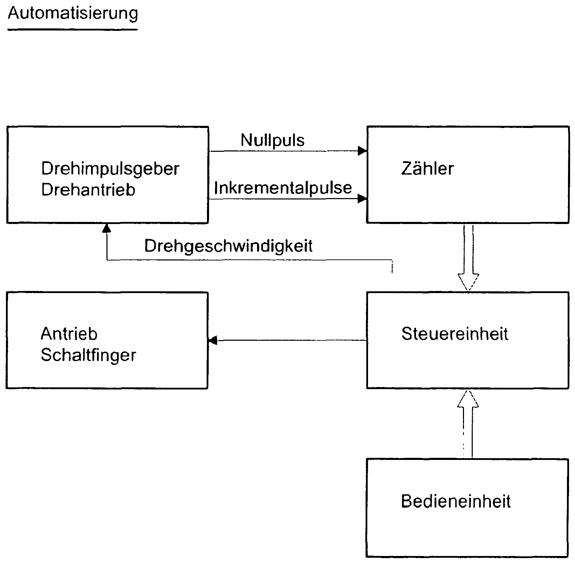

In Figur 8 ist der Ablauf eines Testglaswechsels dargestellt.

Ein Drehimpulsgeber ist mit der Drehachse des Substrathalters 2 (z.B. Kalotte, Planteller) starr ohne Schlupf gekoppelt.

Der Drehimpulsgeber liefert bei jeder Umdrehung einen Nullimpuls bei immer dem gleichen Drehwinkel. Weiterhin wird während der Drehung eine fest definierte Anzahl von Inkrementalpulsen pro Drehwinkel generiert. Bevorzugt wird ein Drehimpulsgeber mit 8192 Pulsen pro Umdrehung eingesetzt. Das entspricht einer Auflösung von einem Puls pro 2.6 Winkelminuten.

Der Nullpuls wird mit einer Leitung an einen Zähler übertragen. Die Inkrementalpulse werden mit einer zweiten Leitung an den Zähler übertragen. Der Zähler wird mit dem Nullpuls zurückgesetzt und mit den Inkrementalpulsen hochgezählt. Damit entspricht der Zählerstand einem ganz bestimmten Drehwinkel des Substrathalters 2.

Der aktuelle Zählerstand wird von einer Steuereinheit ausgelesen. Damit ist der aktuelle Drehwinkel des Substrathalters 2 relativ zum Nullpuls bekannt. Über eine Kalibrierung kann die Position des Testglaswechslers 1 relativ zum Nullpuls ermittelt werden. Damit ist die aktuelle Position des Testglaswechslers 1 während der Drehung bekannt.

Der Ablauf eines automatischen Testglaswechsels wird im Folgenden beschrieben.

Der Substrathalter 2 wird mit dem Antrieb gedreht. Bei einem vorprogrammierten Drehwinkel wird von der Steuereinheit ein Ausgang zur Aktivierung des Schaltfingers 15 gesetzt. Der Drehwinkel zum Setzten des Ausgangs ist so gewählt, dass der Schaltfinger 15 einschwenkt, kurz bevor ein Dreharm 14 des Wechslers 1 den Schaltfinger 15 passiert.

Bei einem weiteren vorprogrammierten Drehwinkel wird der Ausgang für den Schaltfinger 15 zurückgesetzt, so dass der Schaltfinger 15 wieder zurückschwenkt. Dieser Winkel wird so gewählt, dass der Schaltfinger 15 den Punkt zwischen zwei Auskerbungen 12 gerade überschreitet; vgl. Figur 1. Bei der Variante mit der Kugelfixierung wird der Winkel so gewählt, dass die Kugel 25 gerade in eine Kuhle 35 eintrifft, vgl. Figur 7. Der Wechselvorgang ist somit abgeschlossen.

Die Drehzahl des Antriebes für den Substrathalter 2 ist steuerbar. Während des Wechselvorganges kann die Drehgeschwindigkeit in Abhängigkeit des Drehwinkels jederzeit so angepasst werden, dass einerseits eine sichere Positionierung erfolgt bei möglichst geringer Beanspruchung der mechanischen Bauteile und andererseits der Vorgang möglichst schnell abgeschlossen ist. Danach kann die Drehgeschwindigkeit wieder erhöht werden.

Während die bekannten Systeme in der Praxis nur bei kleinen Sputteranlagen mit einem Drehtellerdurchmesser von 550 mm zuverlässig funktionieren, kann der erfindungsgemäße Testglaswechsler 1 auch auf große Anlagen mit einem Kalottendurchmesser von 1500 mm und mehr angewendet werden, die im Vergleich zu kleinen Sputteranlagen eine unpräzise Mechanik haben. Ferner kann der erfindungsgemäße Testglaswechsler 1 an nahezu jeder beliebigen Stelle auf einem Substrathalter 2 (Kalotte, Planteller, Planetenantrieb) platziert werden. Als Anpassung bestehender Anlagen muss lediglich die Schalteinrichtung aus Schaltfinger 15, Welle 16 und Aktuator 17 vorgesehen werden.

Folglich lässt sich das Prinzip der vorliegenden Erfindung auch auf Anlagen anwenden, bei denen die Beschichtung nicht von innen heraus erfolgt, sondern von oben. In diesem Fall wird der Testglaswechsler 1 um 180° gedreht, so dass die Abdeckplatte 8 zur außen oder oben angeordneten Beschichtungsquelle zeigt und die Trägerplatte 3 auf der Unterseite des Substrathalters angeordnet ist.

Neben der vorstehend genannten Transmissionsmessung können die Schichteigenschaften an den Testglaselementen auch in Reflexion gemessen werden. Bei der Reflexionsmessung kann die Trägerscheibe 3 ohne Öffnung 5 ausgeführt werden.

### Bezugszeichenliste

- 1: Testglaswechsler
- 2: Substrathalter
- 3: Trägerscheibe
- 3a: Abdeckung
- 4: Drehachse
- 5: Öffnung in der Trägerscheibe 3
- 5': Öffnung in der Trägerscheibe 3
- 6: Halterung
- 6a: Testglas
- 7: Aufnahmeöffnung der Halterung 6
- 8: Abdeckscheibe
- 9: Öffnung in der Abdeckscheibe 8
- 10: Zentriervorrichtung
- 11: Lagerelement, Nabe
- 12: Vertiefung
- 13: Aktorelement, Federbolzen
- 14: Dreharm
- 15: Schaltfinger
- 15a: Gelenkvorrichtung
- 16: Welle
- 17: Aktuator
- 18: Federbolzenlagerung
- 19a,b,c,d,f: Schrauben
- 20: Feder
- 25: Kugel
- 26: Aktorelement
- 30: Anschlagöffnung
- 35: Lagerelement, Vertiefung

## Patentansprüche

1. Testglaswechsler (1), der in einer Vakuum-Beschichtungsanlage auf einem beweglichen Substrathalter (2) anordenbar ist, mit
- einer relativ zum Substrathalter (2) feststehend angeordneten Trägerscheibe (3) mit einer Drehachse (4) und einer Durchführung für die Drehachse (4), welche wenigstens eine exzentrisch zur Drehachse (4) angeordnete Meßöffnung (5) aufweist
- einer scheibenartigen Halterung (6) für zumindest ein Testglaselement, welche starr mit der Drehachse (4) verbunden und relativ zum Substrathalter (2) drehbar ist und zumindest zwei exzentrisch zur Drehachse (4) und gegeneinander mit einem Winkelabstand versetzte Ausnehmungen (7) aufweist,
- wobei die Halterung (6) in einem Raumbereich zwischen Substrathalter (2) und der Trägerscheibe (3) anordenbar ist
- mit einer Steuereinrichtung, durch die eine Drehbewegung der Halterung (6) bewirkbar und ein in einer der Ausnehmungen (7) angeordnetes Testglaselement in eine erste Position bringbar ist, die einen kleineren Winkelabstand von der Messposition aufweist, als der Winkelabstand zwischen den Ausnehmungen (7) beträgt.
**dadurch gekennzeichnet, dass** eine Zentriereinrichtung (10) vorgesehen ist, die zumindest ein winkelstarr zum Substrathalter (2) angeordnetes Aktorelement (13, 26) und zumindest ein winkelstarr zur Drehachse (4) angeordnetes und vom Aktorelement mit Federkraft beaufschlagbares Lagerelement (11, 35) aufweist, wobei ausgehend von der ersten Position von der Zentriereinrichtung (10) ein Drehmoment auf die Halterung (6) ausübbar ist, um das Testglaselement in die Messposition zu bringen und durch das Eingreifen des Aktorelementes in das Lagerelement ein Haltemoment auf die Halterung (6) ausübbar ist, um das Testglaselement in der Messposition zu halten, wobei
a) das Lagerelement als eine mit der Drehachse (4) starr verbundene Nabe (11) mit einer Anzahl von am Umfang der Nabe (11) angeordneten Vertiefungen (12) ausgebildet ist und zumindest eine der Vertiefungen (12) einer der Ausnehmungen (7) entspricht, und das Aktorelement als an der Trägerscheibe (3) angeordneter Federbolzen (13) ausgebildet ist, der mit einem freien Ende mit Federkraft in eine der Vertiefungen (12) eingreifen kann, oder
b) das Lagerelement als in der Halterung (6) angeordnete muldenartige Vertiefung (35) ausgebildet ist, wobei die Vertiefung (35) einer der Ausnehmungen (7) entspricht und das Aktorelement eine auf der Trägerscheibe (3) einseitig fixierte Blattfeder (20) und ein zwischen der Halterung (6) und der Trägerscheibe (3) angeordnetes Kugelelement (25) umfasst, wobei das Kugelelement (25) eine in der Trägerscheibe (3) angeordnete Anschlagöffnung (30) hat und mit Federkraft der Blattfeder (20) in die Vertiefung (35) eingreifen kann.

2. Testglaswechsler nach Anspruch 1, **dadurch gekennzeichnet, dass** die Steuereinrichtung eine Anzahl von Dreharmen (14) oder Vorsprüngen umfasst, mittels denen ein Drehmoment auf die Drehachse (4) anwendbar ist, sowie zumindest einen in die jeweiligen Umlaufbahn der Dreharme (8) oder Vorsprünge hineinbewegbaren Schaltfinger (15) aufweist, wobei die Halterung (6) mittels der Dreharme (14) oder Vorsprünge um einen Winkelabstand drehbar ist.

3. Testglaswechsler nach einem der vorhergehenden Ansprüche, **dadurch gekennzeichnet, dass** zwischen der Halterung (6) und der Substrathalterung (2) eine Schutzvorrichtung angeordnet ist, so dass jeweils nur ein einziges Testglaselement in seiner Beschichtungs- und Messposition frei gelassen ist.

4. Testglaswechsler nach Anspruch 3, **dadurch gekennzeichnet, dass** die Schutzvorrichtung als Abdeckscheibe (8) ausgebildet ist, die eine mit der Messposition zur Deckung bringbare Öffnung (9) aufweist.

5. Testglaswechsler nach einem der vorhergehenden Ansprüche, **dadurch gekennzeichnet, dass** zumindest ein Testglaselement als ein kreisförmiges oder ovalförmiges Testglas ausgebildet ist.

6. Testglaswechsler nach einem vorhergehenden Ansprüche, **dadurch gekennzeichnet, dass** zumindest ein Testglaselement als Teil-Glasring ausgebildet ist.

7. Vakuum-Beschichtungsanlage mit einem Testglaswechsler, **dadurch gekennzeichnet, dass** der Testglaswechsler nach einem der vorhergehenden Ansprüche ausgebildet ist.

8. Verfahren zum Testglaswechseln mittels eines Testglaswechslers einer vakuum-Beschichtungsanlage nach einem der Ansprüche 1 bis 6 zur optischen Messung von Schichteigenschaften von Testglaselementen in einer Messposition,
**dadurch gekennzeichnet, dass** eine Zentriereinrichtung (10) vorgesehen ist, die zumindest ein winkelstarr zum Substrathalter (2) angeordnetes Aktorelement (13, 26) und zumindest ein winkelstarr zur Drehachse (4) angeordnetes und vom Aktorelement mit Federkraft beaufschlagbares Lagerelement aufweist, wobei ausgehend von der ersten Position von der Zentriereinrichtung (10) ein Drehmoment auf die Halterung (6) ausgeübt wird, um das Testglaselement in die Messposition zu bringen und durch das Eingreifen des Aktorelementes in das Lagerelement ein Haltemoment auf die Halterung (6) ausgeübt wird, um das Testglaselement in der Messposition zu halten, wobei
c) das Lagerelement als eine mit der Drehachse (4) starr verbundene Nabe (11) mit einer Anzahl von am Umfang der Nabe (11) angeordneten Vertiefungen (12) ausgebildet ist und zumindest eine der Vertiefungen (12) einer der Ausnehmungen (7) entspricht, und das Aktorelement als an der Trägerscheibe (3) angeordneter Federbolzen (13) ausgebildet ist, der mit einem freien Ende mit Federkraft in eine der Vertiefungen (12) eingreift, oder
d) das Lagerelement als in der Halterung (6) angeordnete muldenartige Vertiefung (35) ausgebildet ist, wobei die Vertiefung (35) einer der Ausnehmungen (7) entspricht und das Aktorelement eine auf der Trägerscheibe (3) einseitig fixierte Blattfeder (20) und ein zwischen der Halterung (6) und der Trägerscheibe (3) angeordnetes Kugelelement (25) umfasst, wobei das Kugelelement (25) eine in der Trägerscheibe (3) angeordnete Anschlagöffnung (30) hat und mit Federkraft der Blattfeder (20) in die Vertiefung (35) eingreift.

## Claims

1. A test glass changer (1) mountable in a vacuum coating plant on a movable substrate holder (2) comprising
- a carrier plate (3) fastened to the substrate holder (2) with a rotary spindle (4) and a feedthrough for the rotary spindle (4) having at least one measurement opening (5) arranged eccentrically with respect to the rotary spindle (4),
- a disc-like mount (6) for at least one test glass element which is rigidly connected to the rotary spindle (4) and rotatable relative to the substrate holder (2) and which has at least two recesses (7) offset eccentrically with respect to the rotary spindle (4) and against each other at an angular distance,
- wherein the mount (6) is mountable in a space between the substrate holder (2) and the carrier plate (3)
- with a control device configured to induce a rotational movement of the mount (6) and to bring a test glass element arranged in one of the recesses (7) into a first position having a smaller angular distance from the measuring position than the angular distance between the recesses (7),
**characterized in that** a centering device (10) is provided having at least one actuator element (13, 26) arranged at a fixed angle to the substrate holder (2) and
at least one bearing element (11, 35) which is arranged at a fixed angle to the rotary spindle (4) and can be acted on by the actuator element with a spring force, wherein starting from the first position a torque can be applied by the centering device (10) on the mount (6) in order to bring the test glass element into the measuring position and a holding torque can be applied on the mount (6) by engagement of the actuator element into the bearing element in order to hold the test glass element in the measuring position, wherein
a) the bearing element is formed as a hub (11) connected rigidly to the rotary spindle (4) with a number of indentations (12) arranged on the periphery of the hub (11) and wherein at least one of the indentations (12) corresponds to one of the recesses (7), and the actuator element is formed as a spring pin (13) arranged at the carrier plate (3) and configured to engage with one of the indentations (12) via a free end with a spring force, or
b) the bearing element is formed as a trough-like indentation (35) arranged in the mount (6), the indentation (35) corresponding to one of the recesses (7) and the actuator element comprising a leaf spring (20) fixed at one end to the carrier plate (3) and a ball element (25) arranged between the mount (6) and the carrier plate (3), wherein the ball element (25) has a stop opening (30) formed in the carrier plate (3) and can engage with the indentation (35) with the spring force of the leaf spring (20).

2. The test glass changer according to claim 1, **characterized in that** the control device comprises a number of rotary arms (14) or protrusions, by means of which a torque can be applied to the rotary spindle (4), and has at least one switching finger (15) which can be moved into the respective orbital path of the rotary arms (8) or protrusions, wherein the mount (6) is rotatable by an angular distance by means of the rotary arms (14) or protrusions.

3. The test glass changer according to any one of the preceding claims, **characterized in that** a protective device is arranged between the mount (6) and the substrate holder (2) such that only one single test glass element is exposed in its coating and measuring position.

4. The test glass changer according to claim 3, **characterized in that** the protective device is formed as cover plate (8) which has an opening (9) that can be aligned with the measuring position.

5. The test glass changer according to any one of the preceding claims, **characterized in that** at least one test glass element is formed as a circular or oval test glass.

6. The test glass changer according to any one of the preceding claims, **characterized in that** at least one test glass element is formed as a glass ring part.

7. A vacuum coating plant with a test glass changer, **characterized in that** the test glass changer is formed according to any one of the preceding claims.

8. A method for test glass changing by means of a test glass changer of a vacuum coating plant according to any one of claims 1 to 6 for optically measuring the layer properties of test glass elements in a measuring position,
**characterized in that** a centering device (10) is provided having at least one actuator element (13, 26) arranged at a fixed angle to the substrate holder (2) and
at least one bearing element which is arranged at a fixed angle to the rotary spindle (4) and can be acted on by the actuator element with a spring force, wherein starting from the first position a torque is applied by the centering device (10) on the mount (6) in order to bring the test glass element into the measuring position and a holding torque is applied on the mount (6) by engagement of the actuator element into the bearing element in order to hold the test glass element in the measuring position, wherein
c) the bearing element is formed as a hub (11) connected rigidly to the rotary spindle (4) with a number of indentations (12) arranged on the periphery of the hub (11) and wherein at least one of the indentations (12) corresponds to one of the recesses (7), and the actuator element is formed as a spring pin (13) arranged at the carrier plate (3) and configured to engage with one of the indentations (12) via a free end with a spring force, or
d) the bearing element is formed as a trough-like indentation (35) arranged in the mount (6), the indentation (35) corresponding to one of the recesses (7) and the actuator element comprising a leaf spring (20) fixed at one end to the carrier plate (3) and a ball element (25) arranged between the mount (6) and the carrier plate (3), wherein the ball element (25) has a stop opening (30) formed in the carrier plate (3) and engages with the indentation (35) with the spring force of the leaf spring (20).

## Revendications

1. Changeur de tubes à essai (1), pouvant être disposé sur un support de substrat (2) mobile dans une installation de revêtement sous vide, comprenant
- un disque de support (3) disposé fixement par rapport au support de substrat (2), avec un axe de rotation (4) et une traversée pour l'axe de rotation (4), et qui présente au moins une ouverture de mesure (5) ménagée excentriquement à l'axe de rotation (4),
- un support (6) en forme de plaque pour au moins un élément de tube à essai, fixement raccordé à l'axe de rotation (4) et rotatif par rapport au support de substrat (2) et au moins présentant deux évidements (7) excentrés par rapport à l'axe de rotation (4) et décalés d'une distance angulaire l'un par rapport à l'autre,
- le support (6) pouvant être disposé dans une zone entre le support de substrat (2) et le disque de support (3),
- comprenant un dispositif de commande permettant une rotation du support (6) et l'amenée dans une première position d'un élément de tube à essai disposé dans un des évidements (7), dont l'espacement angulaire à la position de mesure est inférieur à l'espacement angulaire entre les évidements (7),
**caractérisé en ce qu'**un dispositif de centrage (10) est prévu, lequel comprend au moins un élément actionneur (13, 26) disposé avec un angle fixe par rapport au support de substrat (2), et au moins un élément de palier (11, 35) disposé avec un angle fixe par rapport à l'axe de rotation (4) et pouvant être soumis à une force de ressort de l'élément actionneur, un couple de rotation pouvant être exercé sur le support (6) à partir de la première position par le dispositif de centrage (10) pour amener l'élément de tube à essai en position de mesure, et un couple d'arrêt pouvant être exercé sur le support (6) par engagement de l'élément actionneur dans l'élément de palier pour maintenir l'élément de tube à essai en position de mesure,
a) l'élément de palier étant réalisé comme moyeu (11) fixement raccordé à l'axe de rotation (4) avec une pluralité de renfoncements (12) prévus sur la circonférence du moyeu (11), et au moins un des renfoncements (12) correspondant à un des évidements (7), et l'élément actionneur étant réalisé comme verrou élastique (13) disposé sur le disque de support (3), lequel peut s'engager dans un des renfoncements (12) par une extrémité libre sous l'effet d'une force de ressort, ou
b) l'élément de palier étant réalisé comme évidement (35) en forme d'auge dans le support (6), ledit évidement (35) correspondant à un des évidements (7) et l'élément actionneur comprenant un ressort à lame (20) fixé sur un côté du disque de support (3) et un élément sphérique (25) disposé entre le support (6) et le disque de support (3), ledit élément sphérique (25) présentant une ouverture de butée (30) ménagée dans le disque de support (3) et pouvant s'engager dans l'évidement (35) sous la force élastique du ressort à lame (20).

2. Changeur de tubes à essai selon la revendication 1, **caractérisé en ce que** le dispositif de commande comprend une pluralité de bras rotatifs (14) ou de saillies au moyen desquels un couple de rotation peut être appliqué sur l'axe de rotation (4), ainsi qu'au moins un doigt de commutation (15) déplaçable vers chaque orbite des bras rotatifs (8) ou saillies, le support (6) étant rotatif suivant un espacement angulaire au moyen des bras rotatifs (14) ou des saillies.

3. Changeur de tubes à essai selon l'une des revendications précédentes, **caractérisé en ce qu'**un dispositif de protection est présenté entre le support (6) et le support de substrat (2), de manière à ne libérer qu'un seul élément de tube à essai dans sa position de revêtement et de mesure.

4. Changeur de tubes à essai selon la revendication 3, **caractérisé en ce que** le dispositif de protection est réalisé comme disque de couverture (8) présentant une ouverture (9) pouvant être mise en recouvrement sur la position de mesure.

5. Changeur de tubes à essai selon l'une des revendications précédentes, **caractérisé en ce qu'**au moins un élément de tube à essai est réalisé comme tube à essai de forme circulaire ou ovale.

6. Changeur de tubes à essai selon l'une des revendications précédentes, **caractérisé en ce qu'**au moins un élément de tube à essai est réalisé comme tube annulaire partiel.

7. Installation de revêtement sous vide avec un changeur de tubes à essai, **caractérisée en ce que** le changeur de tubes à essai est réalisé selon l'une des revendications précédentes.

8. Procédé de changement de tubes à essai au moyen d'un changeur de tubes à essai d'une installation de revêtement sous vide selon l'une des revendications 1 à 6 pour la mesure optique des propriétés de couche d'éléments de tube à essai dans une position de mesure,
**caractérisé en ce qu'**un dispositif de centrage (10) est prévu, lequel comprend au moins un élément actionneur (13, 26) disposé avec un angle fixe par rapport au support de substrat (2), et au moins un élément de palier disposé avec un angle fixe par rapport à l'axe de rotation (4) et pouvant être soumis à une force de ressort de l'élément actionneur, un couple de rotation pouvant être exercé sur le support (6) à partir de la première position par le dispositif de centrage (10) pour amener l'élément de tube à essai en position de mesure, et un couple d'arrêt pouvant être exercé sur le support (6) par engagement de l'élément actionneur dans l'élément de palier pour maintenir l'élément de tube à essai en position de mesure,
c) l'élément de palier étant réalisé comme moyeu (11) fixement raccordé à l'axe de rotation (4) avec une pluralité de renfoncements (12) prévus sur la circonférence du moyeu (11), et au moins un des renfoncements (12) correspondant à un des évidements (7), et l'élément actionneur étant réalisé comme verrou élastique (13) disposé sur le disque de support (3), lequel peut s'engager dans un des renfoncements (12) par une extrémité libre sous l'effet d'une force de ressort, ou
d) l'élément de palier étant réalisé comme évidement (35) en forme d'auge dans le support (6), ledit évidement (35) correspondant à un des évidements (7) et l'élément actionneur comprenant un ressort à lame (20) fixé sur un côté du disque de support (3) et un élément sphérique (25) disposé entre le support (6) et le disque de support (3), ledit élément sphérique (25) présentant une ouverture de butée (30) ménagée dans le disque de support (3) et pouvant s'engager dans l'évidement (35) sous la force élastique du ressort à lame (20).
